# EUROPEAN PATENT APPLICATION

(11) **EP 1 733 853 A1**
(43) Date of publication of application: **20.12.2006**
(21) Application number: 05709446.8
(22) Date of filing: 28.01.2005
(51) Int. Cl.: B25J 15/06, H01L 21/68, H05K 13/02, H05K 13/08

(54) **VACUUM SUCTION UNIT**

(30) Priority: 17.03.2004 JP 2004075763
(71) Applicant: Koganei Corporation, Chiyoda-ku, Tokyo 101-0032 (JP)
(72) Inventor: FUJIWARA, Teruhiko; c/o Koganei Corporation,, Tokyo 101-0032 (JP)
(74) Representative: Hering, Hartmut
(86) International application number: PCT/JP2005/001220
(87) International publication number: WO 2005/090011

(57) **Abstract**

As shown in FIG. 1, a suction device 13 which vacuum-sucks a workpiece W is connected to an attaching/detaching flow path 14. Negative pressure air in a vacuum supply source 11 is supplied to the attaching/detaching flow path 14 via a vacuum supply control valve 15. The vacuum supply control valve 15 is switched to a vacuum-hold position where the negative pressure air is supplied to the attaching/detaching flow path 14 and a rest position where the supply is stopped. A flow rate sensor 29 which detects flow of the air in the attaching/detaching flow path 14 is connected to the attaching/detaching flow path 14. When a detected value of the flow rate sensor 29 is equal to or less than a predetermined judgment value, it is judged that the workpiece W has been vacuum-held.

## Description

### TECHNICAL FIELD

The present invention relates to a vacuum sucking unit provided with a suction device which vacuum-holds a workpiece.

### BACKGROUND ART

When mounting a workpiece such as an IC or LSI on an inspection board or mounting the already inspected workpiece on a printed circuit board, there is used a carrying apparatus for carrying the workpiece to be arranged in a tray or the like.

As the above-mentioned carrying apparatus, there is an apparatus of a type in which a suction device movable in a Z direction is attached to a carrying head movable in X and Y directions, and the workpiece is carried to a predetermined position while being vacuum-held to the suction device. As the above-mentioned suction device, there is a device of a type of supplying negative pressure therein and of vacuum-holding the workpiece by differential pressure between atmospheric pressure and the negative pressure. An opening portion of an airflow path formed in the suction device serves as a suction port which vacuum-holds the workpiece. As a negative pressure source for supplying negative pressure air, that is, vacuum to the suction port, there are the case of using a vacuum pump and the case of using an ejector to which compressed air is supplied so as to generate the negative pressure. In the case where the vacuum pump is used as the negative pressure source, a valve which opens and closes a flow path is provided in an airflow path between the suction port and the negative pressure source. On the other hand, in the case where the ejector is used as the negative pressure source, the negative pressure is supplied to the suction port via the airflow path from the ejector when positive pressure air is supplied to the ejector, and the supply of the negative pressure is stopped when the supply of the positive pressure air to the ejector is stopped. When the workpiece vacuum-held by the suction device is detached from the suction device, detach performance of the workpiece can be improved not only by stopping the supply of the negative pressure to the suction device but also by supplying the positive pressure air to the suction device via the airflow path.

In the carrying apparatus, it is necessary to move the suction device after making a vacuum-holding judgment about whether the workpiece is vacuum-held to the suction device or whether the workpiece is detached therefrom. Conventionally, as described in patent document 1, the vacuum-holding judgment has been made by detecting a change of air pressure in the suction device. This judging method utilizes a phenomenon in which if the workpiece is vacuum-held to the suction port of the suction device, ambient air is not sucked from the suction port and the negative pressure in the suction device is increased. By utilizing the method, when the negative pressure detected by using the pressure sensor is increased to a level equal to or more than a predetermined judgment value, the vacuum-holding of the workpiece is judged.

Patent Document 1: Japanese Patent Laid-Open Publication No. 11-214893

### DISCLOSURE OF THE INVENTION

Incidentally, the pressure of the negative pressure air supplied to the suction device is changed by a pulsation of the vacuum pump, a fluctuation in a vacuum regulator, a reduction of the negative pressure caused by allocating the negative pressure air to other circuits, or the like when the vacuum pump is used as a vacuum supply source. Therefore, in the conventional judging method in which the vacuum-holding judgment is made by a pressure change in the suction device, it is necessary to change the judgment value in accordance with the supplied negative air pressure and the judgment method becomes complicated accordingly. In recent years, electronic parts have become very small, and it becomes expensive to make the vacuum-holding judgment by an image recognition apparatus.

An object of the present invention is to provide a vacuum sucking unit which can stably make a vacuum-holding judgment without being affected by a pressure change of negative pressure air supplied to a suction device.

A vacuum sucking unit according to the present invention comprises: a unit block provided with a vacuum-holding port connected to the suction device which vacuum-holds a workpiece, an attaching/detaching flow path being formed in the unit block; a vacuum supply control valve mounted in the unit block and operating at a state of supplying negative pressure air to the attaching/detaching flow path and at a state of stopping the supply; a vacuum break control valve mounted in the unit block and operating at a state of supplying positive pressure air to the attaching/detaching flow path and at a state of stopping the supply; and a flow rate sensor mounted in the unit block and detecting a flow rate of air flowing in the attaching/detaching flow path, wherein vacuum-holding of the workpiece to the suction device is judged by the flow rate of the air within the attaching/detaching flow path.

The vacuum sucking unit according to the present invention is such that a vacuum input port connected to a vacuum supply source via the vacuum supply control valve is switched to a state of communicating with the attaching/detaching flow path and a state of blocking the communication.

The vacuum sucking unit according to the present invention is such that the unit block is provided with an ejector comprising an air supply port connected to a positive pressure supply source and a suction port communicating with the attaching/detaching flow path, and the vacuum supply control valve is switched to a state of supplying compressed air to the air supply port to supply the negative pressure air to the attaching/detaching flow path via the suction port and to a state of stopping supply of the compressed air to the air supply port to stop supply of the negative pressure air to the attaching/detaching flow path.

The vacuum sucking unit according to the present invention is such that the unit block is provided with a filter which removes a foreign material flowing into the attaching/detaching flow path.

According to the present invention, since the vacuum-holding judgment is made by utilizing a phenomenon in which the flow rate of the air within the attaching/detaching path connected to the suction device is reduced when the workpiece is vacuum-held, it is possible to securely make the vacuum-holding judgment without being affected by a pressure change of the negative pressure air supplied to the suction device. In addition, since the judgment value can be set without being affected by the pressure change of the negative pressure air supplied to the suction device, the vacuum-holding judgment can be stably made.

### BRIEF DESCRIPTION OF THE DRAWINGS

FIGS. 1A and 1B are circuit diagrams showing an air pressure circuit of a vacuum sucking unit according to an embodiment of the present invention, wherein FIG. 1A shows a switching position at vacuum supply and FIG. 1B shows a switching position at vacuum break;
FIG. 2 is a partial cross-sectional view showing a vacuum sucking unit according to an embodiment of the present invention;
FIG. 3 is a cross-sectional view taken along line A-A in FIG. 2;
FIGS. 4A and 4B are circuit diagrams showing a vacuum sucking unit according to another embodiment of the present invention, wherein FIG. 4A shows a switching position at the vacuum supply and FIG. 4B shows a switching position at the vacuum break; and
FIG. 5 is a partial cross-sectional view showing a vacuum sucking unit according to another embodiment of the present invention.

### BEST MODE FOR CARRYING OUT THE INVENTION

Hereinafter, embodiments according to the present invention will be described in detail on the basis of the accompanying drawings.

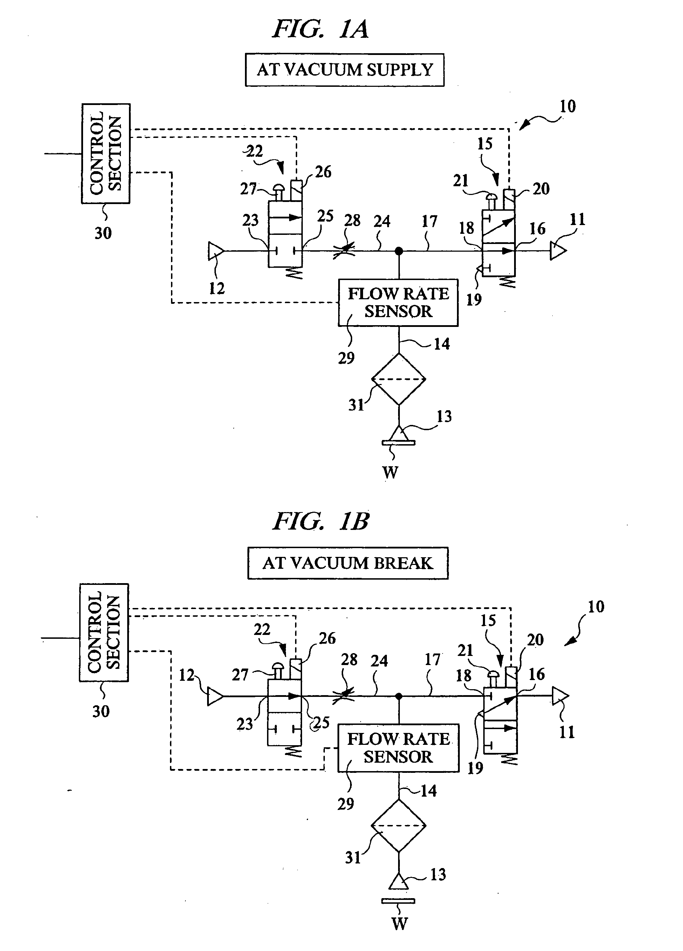

FIGS. 1A and 1B are circuit diagrams showing an air pressure circuit of a vacuum sucking unit according to an embodiment of the present invention, wherein FIG. 1A shows a switching position at vacuum supply and FIG. 1B shows a switching position at vacuum break. As shown in FIG. 1, a vacuum sucking unit 10 is connected to a vacuum supply source 11 having a vacuum pump as a vacuum generating source and to a positive pressure supply source 12 having a compression pump as a positive pressure generating source, and has an attaching/detaching flow path 14 connected to an suction device 13 such as a vacuum pad. A workpiece W is vacuum-sucked to the suction device 13 by supplying negative pressure air to the attaching/detaching flow path 14 from the vacuum supply source 11. On the other hand, when detaching the workpiece W from the suction device 13, the workpiece W is detached from the suction device 13 by stopping the supply of the negative pressure air to the attaching/detaching flow path 14 from the vacuum supply source 11, and forcibly detached by supplying positive pressure air from the positive pressure supply source 12.

The vacuum sucking unit 10 has a vacuum supply control valve 15 which operates, with respect to the attaching/detaching flow path 14, at a state of supplying the negative pressure air from the vacuum supply source 11 to the suction device 13 and at a state of stopping the supply. The vacuum supply control valve 15 is a three-port two-position switching valve comprising a vacuum input port 16 connected to the vacuum supply source 11, a vacuum output port 18 communicating with the attaching/detaching flow path 14 via a vacuum flow path 17, and an atmospheric air open port 19 communicating with an external. Thereby, the negative pressure air is supplied to the attaching/detaching flow path 14 when the vacuum input port 16 communicates with the vacuum output port 18, and the supply of the negative pressure air to the attaching/detaching flow path 14 is stopped if the communication between the vacuum input port 16 and the attaching/detaching flow path 14 is blocked.

Switching control of two positions with respect to the vacuum supply control valve 15 is executed by current-carrying control to a solenoid 20 provided in the vacuum supply control valve 15, and the vacuum supply control valve 15 is switched to, for example, a detaching position of stopping the negative pressure supply to the attaching/detaching flow path 14 when a current is carried to the solenoid 20 or a vacuum-hold position of supplying the negative pressure to the attaching/detaching flow path 14 when the current is blocked. If being illustrated, a manual button 21 is provided in the vacuum supply control valve 15, so that it is possible to switch from the vacuum-hold position to the detaching position by pressing the manual button 21.

The vacuum sucking unit 10 has a vacuum break control valve 22 which operates at a state of supplying compressed air, that is, positive pressure air from the positive pressure supply source 12 to the attaching/detaching flow path 14 and at a state of stopping the supply. The vacuum break control valve 22 is a two-port two-position switching valve comprising a positive pressure input port 23 communicating with the positive pressure supply source 12 and a positive pressure output port 25 communicating with the attaching/detaching flow path 14 via a vacuum break flow path 24. Thereby, the positive pressure air is supplied to the attaching/detaching flow path 14 when the positive pressure input port 23 and the positive pressure output port 25 communicate with each other, and the supply of the positive pressure air to the attaching/detaching flow path 14 is blocked when the communication between the positive pressure input port 23 and the positive pressure output port 25 is blocked.

The switching control of two positions with respect to the vacuum break control valve 22 is executed by current-carrying control to a solenoid 26 provided in the vacuum break control valve 22. The vacuum break control valve 22 is switched to a vacuum break position of supplying the positive pressure air to the attaching/detaching flow path 14 when the current is carried to the solenoid 26, and to a rest position of stopping the supply of the positive pressure air to the attaching/detaching flow path 14 when the current is blocked. Further, a manual button 27 is provided in the vacuum break control valve 22, so that the vacuum break control valve 22 is forcibly switched to the detaching position by pressing the manual button 27.

Incidentally, as the vacuum supply control valve 15, a two-port valve can be used like the vacuum break control valve 22 instead of an illustrated three-port valve and, in this case, operates at two positions, i.e., at a state of communicating with the vacuum input port 16 and the vacuum output port 18 and at a state of blocking the communication.

The vacuum sucking unit 10 has a throttle valve 28 for adjusting a flow-path area of the vacuum break flow path 24. By the throttle valve 28, it is possible to adjust a flow rate of the positive pressure air supplied from the positive pressure supply source 12.

In order to detect whether air flows in the attaching/detaching flow path 14 or whether air hardly flows therein, the vacuum sucking unit 10 has a flow rate sensor 29. The flow rate of air flowing in the attaching/detaching flow path 14 is detected per unit time by the flow rate sensor 29. The detected flow rate of air is converted into a voltage value and is transmitted to a control section 30 as a detected signal. The control section 30 is provided with: a microprocessor which computes a detected signal; a ROM which stores control program, data table, and the like; a RAM which temporarily stores data; and the like. A judgment value for making a vacuum-holding judgment is also stored in the control section 30. The control section 30 executes current-carrying control to the solenoids 20 and 26 of the vacuum supply control valve 15 and the vacuum break control valve 22.

A filter 31 is arranged between the flow rate sensor 29 and the suction device 13 in the attaching/detaching flow path 14. By the filter 31, foreign materials such as dust or drain flowing in the attaching/detaching flow path 14 are removed, so that the control valves 15 and 22 are protected and interiors of the flow paths 14, 17 and 24 are prevented from clogging.

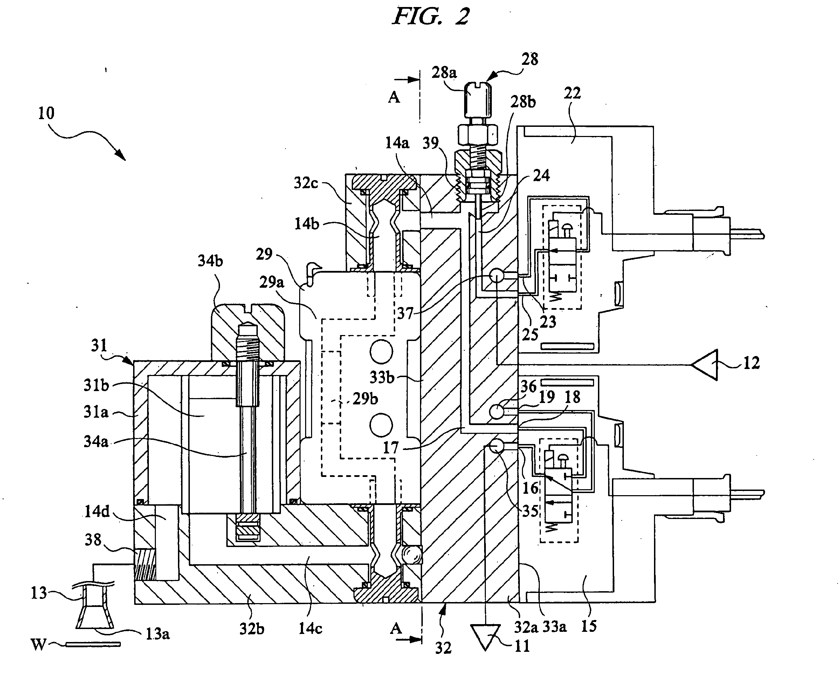

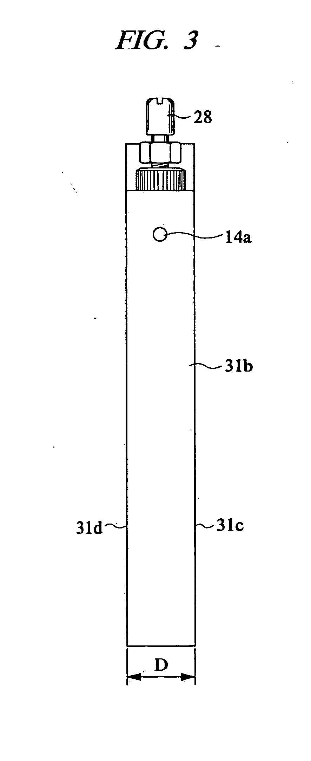

FIG. 2 is a partial cross-sectional view showing a vacuum sucking unit according to an embodiment of the present invention, and FIG. 3 is a cross-sectional view taken along line A-A in FIG. 2. The vacuum sucking unit 10 has a unit block 32 provided with a base block 32a, a connection block 32b, and a communication block 32c. Each of the blocks 32a to 32c has a quadrilateral cross-section, thereby being formed into a rectangular parallelepiped shape. The connection block 32b and the communication block 32c have thickness corresponding to thickness "D" of the base block 32a as shown in FIG. 3. The vacuum supply control valve 15 and the vacuum break control valve 22 are assembled on one side surface 33a of the base block 32a, and the connection block 32b and the communication block 32c are assembled on an opposite side surface 33b so as to be spaced from each other. As mentioned above, a plurality of members are assembled with respect to the unit block 32, whereby the vacuum sucking unit 10 is unitized.

The flow rate sensor 29 is assembled to the unit block 32 in such a manner as to be sandwiched between the connection block 32b and the communication block 32c. The filter 31 is assembled to the connection block 32b. The filter 31 has a filter case 31a and a filter element 31b incorporated in the filter case 31a, and the filter case 31a is assembled to the connection block 32b by screwing a nut 34b on a screw member 34a fixed to the connection block 32b.

A vacuum supply hole 35 communicating with the vacuum input port 16 of the vacuum supply control valve 15 and an atmosphere communication hole 36 communicating with an atmosphere open port 19 are formed in the base block 32a, and the vacuum supply hole 35 is connected to the vacuum supply source 11 through a flow path. A positive pressure supply hole 37 communicating with the positive pressure input port 23 of the vacuum break control valve 22 is formed in the base block 32a, and this positive pressure supply hole 37 is connected to the positive pressure supply source 12 through a flow path.

A vacuum-holding port 38 is provided in the connection block 32b, and the suction device 13 is attached directly or via a vacuum-holding tube or vacuum-holding hose to the vacuum-holding port 38. The attaching/detaching flow path 14, the vacuum flow path 17 and the vacuum break flow path 24 are formed in the unit block 32, and the attaching/detaching flow path 14 is formed by a flow path 14a formed in the base block 32c, a flow path 14b formed in the communication block 32c, and flow paths 14c and 14d formed in the connection block 32b. A throttle valve 28 for adjusting a flow-path area of the vacuum break flow path 24 is mounted in a screw hole 39 formed in the base block 32a. The throttle valve 28 is a variable throttle provided with a needle 28b which is reciprocably inserted into the vacuum break flow path 24 by rotating an operation portion 28a. Therefore, the throttle valve 28 can adjust the flow rate of the positive pressure air flowing in the vacuum break flow path 24 by varying the flow path area of the vacuum break flow path 24.

As shown in FIG. 2, the flow rate sensor 29 has a sensor case 29a attached to the unit block 32, a flow path communicating with the flow paths 14b and 14c and constituting a part of the attaching/detaching flow path 14 is formed in the sensor case, and a detection body 29b which detects flow of the air within the flow path is provided in the sensor case 29a.

In order to vacuum-hold the workpiece W to the suction device 13 by using the vacuum sucking unit 10 mentioned above, as shown in FIG. 1A, the vacuum supply control valve 15 is switched to the vacuum-hold position and the vacuum break control valve 22 is switched to the rest position. By doing so, the attaching/detaching flow path 14 connected to the suction device 13 communicates with the vacuum supply source 11 via the vacuum flow path 17, and the workpiece W is sucked by setting an inside of the suction device 13 to a negative pressure state. In this case, in a state in which the workpiece W is not vacuum-held to the suction device 13, the suction device 13 sucks external air and thereby the airflow is generated in the attaching/detaching flow path 14. The airflow is detected by the detection body 29b of the flow rate sensor 29, and a detected signal is sent to the control section 30.

On the other hand, if the workpiece W is vacuum-held to the suction port 13a of the suction device 13, external air is not sucked from the suction port 13a and the flow rate of the air in the attaching/detaching flow path 14 becomes approximately zero, so that it is judged on the basis of the detected signal from the detection body 29b of the flow rate sensor 29 that the suction device 13 has vacuum-held the workpiece W. According to the present invention, when it is judged that the value of the flow rate of the air detected by the flow rate sensor 29 is equal to or less than a predetermined judgment value by the flow state of the air within the attaching/detaching flow path 14, it is determined that the workpiece W is vacuum-held to the suction device 13. The judgment value is a value which is previously determined before vacuum-holding and judgment, and can be set to a value close to zero in consideration of a measurement error and a leakage of the vacuum-held portion.

As mentioned above, the pressure of the negative pressure air supplied to the suction device 13 is changed by pulsation of the vacuum pump in the case of using a vacuum pump as the vacuum supply source 11, fluctuation in a vacuum regulator, a reduction of the negative pressure due to allocation of negative pressure air to other circuits, or the like. Therefore, a suction force and the value of the flow rate of the air detected by the flow rate sensor 29 do not become constant. However, a phenomenon in which the flow rate of the air in the attaching/detaching flow path 14 becomes approximately zero is always caused when the workpiece W is vacuum-held to the suction device 13, so that the vacuum-holding judgment is securely made by utilizing such a phenomenon. In addition, since the stable judgment value can be set without being affected by the pressure change of the negative pressure air supplied to the suction device 13, the vacuum-holding judgment can be stably made.

Conveyance of the workpiece W is carried out after the vacuum-holding judgment of the workpiece W. If the workpiece W reaches a predetermined position, supply of the negative pressure air to the suction device 13 is stopped by actuating the vacuum supply control valve 15. Concurrently, when the workpiece W is light in weight and is not detached only by its own weight, the workpiece W can be mounted at a predetermined position by switching the vacuum break control valve 22 to the vacuum break position, as shown in FIG. 1B.

The vacuum sucking unit 10 shown in FIGS. 1 to 3 becomes an assembly by assembling a plurality of members to the unit block 32 and is unitized, and is further formed into a thick dimension D as a whole. Therefore, the vacuum sucking unit can be not only used as a single body but also formed into a manifold shape by laminating a plurality of vacuum sucking units 10 and jointing the number of necessary tie rods, assembling screws, metal linking fitting, or the like.

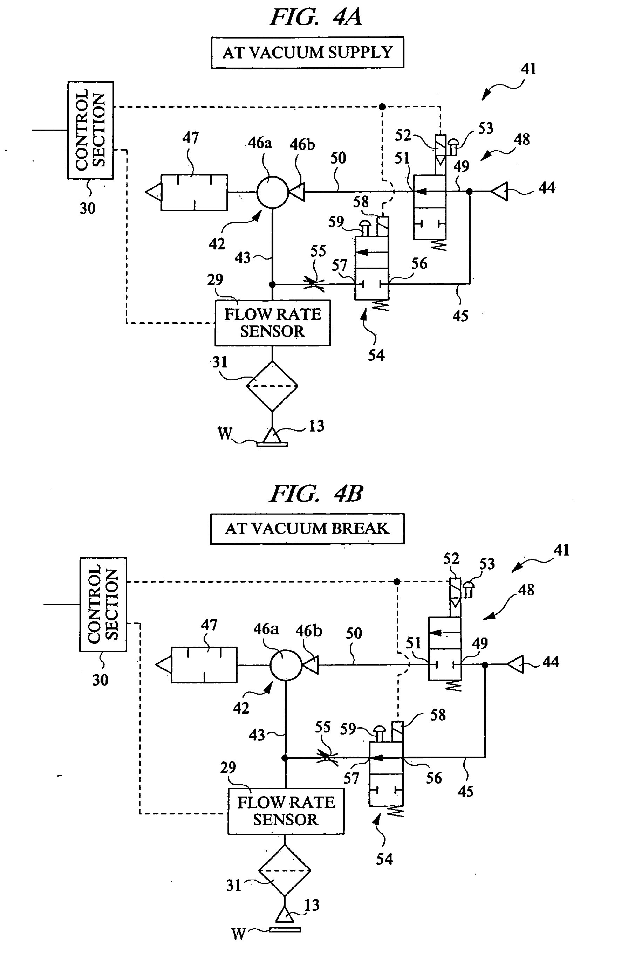

FIGS. 4A and 4B are circuit diagrams of a vacuum sucking unit according to another embodiment of the present invention, wherein FIG. 4A shows a switching position at vacuum supply and FIG. 4B shows a switching position at vacuum break. The above-mentioned vacuum sucking unit 10 supplies, to the suction device 13, the negative pressure supplied from the vacuum supply source 11. In contrast, a vacuum sucking unit 41 has an ejector 42 serving as a vacuum generating source, so that the negative pressure air generated in the ejector 42 is guided into an attaching/detaching flow path 43 connected to the suction device 13 and thereby the workpiece W is vacuum-sucked to the suction device 13 and that the positive pressure air from a positive pressure supply source 44 is guided to a vacuum break flow path 45 and thereby the workpiece W is forcibly detached from the suction device 13.

The ejector 42 has a diffuser 46a constituting an ejector main body and a nozzle 46b which sprays compressed air to the diffuser 46a, and sound of the air having passed through the diffuser 46a is muffled by a muffler 47 and is exhausted to the outside. The nozzle 46b is connected to the positive pressure supply source 44 through a compressed air flow path 50, and the compressed air flow path 50 is provided with a vacuum supply control valve 48 which makes the ejector 42 operate at a state of supplying the negative pressure air to the attaching/detaching flow path 43 and at a state of stopping the supply. The vacuum supply control valve 48 is a two-port two-position switching valve comprising a positive pressure input port 49 communicating with the positive pressure supply source 44 and a positive pressure output port 51 communicating with the compressed air flow path 50. The vacuum supply control valve 48 operates at a vacuum-hold position of supplying the compressed air to the nozzle 46b, generating vacuum in the diffuser 46a, and supplying the negative pressure air to the attaching/detaching flow path 43, and at a rest position of stopping the supply of the compressed air to the nozzle 46b and stopping the supply of the negative pressure air to the attaching/detaching flow path 43.

The switching control at the vacuum-hold position and the stop position is executed by current-carrying control to a solenoid 52 provided in the vacuum supply control valve 48, so that the vacuum supply control valve 48 is switched to the vacuum-hold position when the current is carried, and is switched to the rest position when the current is stopped. When being illustrated, a manual button 53 is also provided in the vacuum supply control valve 48, so that it is possible to switch from the rest position to the vacuum-hold position by pressing the manual button 53.

A vacuum break control valve 54 is arranged in the vacuum break flow path 45, and the vacuum break flow path 45 is connected to the attaching/detaching flow path 43 via the vacuum break control valve 54 and a throttle valve 55. The vacuum break control valve 54 is a two-port two-position switching valve comprising a positive pressure input port 56 communicating with the positive pressure supply source 44 and a positive pressure output port 57 communicating with the vacuum break flow path 45, and has a vacuum break position of communicating with the positive pressure input port 56 and the positive pressure output port 57, and a rest position of blocking the communication between the positive pressure input port 56 and the positive pressure output port 57.

The switching control at the vacuum break position and the rest position is executed by current-carrying control to a solenoid 58 provided in the vacuum break control valve 54, so that the vacuum break control valve 54 is switched to a forcibly detaching position when the current is carried and to the rest position when the current is stopped. When being illustrated, a manual button 59 is also provided in the vacuum break control valve 54, so that it is possible to switch from the rest position to the vacuum break position by pressing the manual button 59.

The throttle valve 55 is provided in the vacuum break flow path 45, thereby making it possible to adjust the flow rate of the positive pressure air supplied from the positive pressure supply source 44. In addition, the same flow rate sensor 29 and filter 31 as those shown in FIGS. 1A, 1B and 2 are respectively arranged in the attaching/detaching flow path 43.

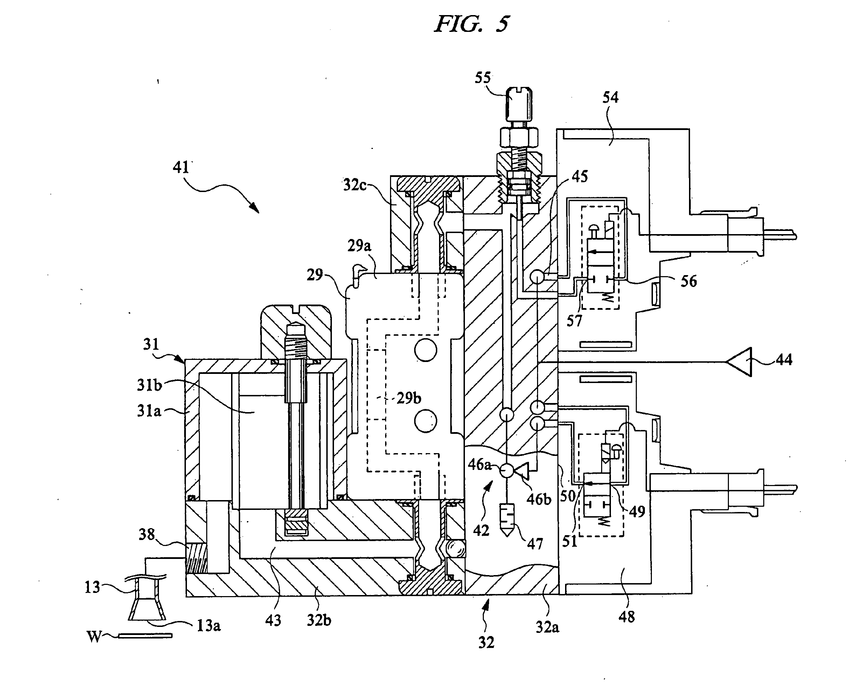

FIG. 5 is a partial cross-sectional view showing a vacuum sucking unit according to another embodiment of the present invention. In the same manner as the vacuum sucking unit 10 shown in FIG. 2, the vacuum sucking unit 41 has the unit block 32 provided with the base block 32a, the connection block 32b, and the communication block 32c, wherein the vacuum supply control valve 48, the vacuum break control valve 54, the flow rate sensor 29, and the filter 31 may be assembled in the unit block 32.

In order to make the suction device 13 vacuum-hold the workpiece W by using the vacuum sucking unit 41, as shown in FIG. 4A, the vacuum supply control valve 48 is switched to the vacuum-hold position and the vacuum break control valve 54 is switched to the rest position. By doing so, the vacuum generated in the ejector 42 is supplied to the attaching/detaching flow path 43 to make the inside of the suction device 13 change to a negative pressure state, whereby the workpiece W can be sucked.

The vacuum-holding judgment of the workpiece W is made by the same means as the above-mentioned vacuum sucking unit 10. In other words, the flow rate of the air in the attaching/detaching flow path 43 is detected by the flow rate sensor 29, the detected signal is transmitted to the control section 30, and the vacuum-holding judgment of the workpiece W is made by comparing the detected signal with the predetermined judgment value. The pressure of the negative pressure air supplied to the suction device 13 may be varied by the pressure change of the compressed air supplied to the ejector 42 serving as the vacuum supply source. However, the secure vacuum-holding judgment can be stably made by judging the flow of the air in the attaching/detaching flow path 43 at a time of vacuum-holding the workpiece W. The actuation of the vacuum supply control valve 48 and the vacuum break control valve 54 is controlled by the control signal from the control section 30.

The conveyance of the workpiece W is carried out after the vacuum-holding judgment of the workpiece W. If the workpiece W reaches a predetermined position, the vacuum supply control valve 48 is switched to the detaching position. Even if the workpiece W is light in weight and is not detached only by its own weight, the workpiece W can be mounted at the predetermined position by switching the vacuum break control valve 54 to the vacuum break position, as shown in FIG. 4B.

The present invention is not limited to the above-mentioned embodiments, and can be variously modified within the scope of not departing from the gist thereof. For example, the illustrated switching method by the vacuum supply control valves 15 and 48 and the vacuum break control valves 22 and 54 is merely one embodiment, and such a method can be variously modified to a direct-acting type valve, a double solenoid type valve, or the like for use. The suction device 13 to be connected is not limited to one, and a plurality of suction devices may be connected to a tip of the filter 31. In the case where the workpiece W can be detached even if the positive pressure air is not supplied to the suction device 13, it is possible to omit arrangement of the positive pressure supply sources 12 and 44, the vacuum break control valves 22 and 54, and the throttle valves 28 and 55.

### INDUSTRIAL APPLICABILITY

This vacuum sucking unit can be used for stably detecting vacuum-holding and drop of the workpiece without being affected by the pressure change of the negative pressure air supplied to the suction device at a time of carrying the workpiece such as a IC, or LSI to the inspection board, the printed circuit board, or the like while being vacuum-sucked, and for securely carrying out the vacuum-holding and the drop of the workpiece.

## Claims

1. A vacuum sucking unit provided with a suction device which vacuum-holds a workpiece, the unit comprising:
a unit block provided with a vacuum-holding port connected to the suction device, an attaching/detaching flow path being formed in the unit block;
a vacuum supply control valve mounted on the unit block and operating at a state of supplying negative pressure air to the attaching/detaching flow path and at a state of stopping the supply;
a vacuum break control valve mounted on the unit block and operating at a state of supplying positive pressure air to the attaching/detaching flow path and at a state of stopping the supply; and
a flow rate sensor mounted in the unit block and detecting a flow rate of air flowing in the attaching/detaching flow path,
wherein vacuum-holding of the workpiece to the suction device is judged by the flow rate of the air within the attaching/detaching flow path.

2. The vacuum sucking unit according to claim 1, wherein a vacuum input port connected to a vacuum supply source via the vacuum supply control valve is switched to a state of communicating with the attaching/detaching flow path and a state of blocking the communication.

3. The vacuum sucking unit according to claim 1, wherein the unit block is provided with an ejector comprising an air supply port connected to a positive pressure supply source and a suction port communicating with the attaching/detaching flow path, and the vacuum supply control valve is switched to a state of supplying compressed air to the air supply port to supply the negative pressure air to the attaching/detaching flow path via the suction port and to a state of stopping supply of the compressed air to the air supply port to stop supply of the negative pressure air to the attaching/detaching flow path.

4. The vacuum sucking unit according to claim 1, wherein the unit block is provided with a filter which removes a foreign material flowing into the attaching/detaching flow path.
